# EUROPÄISCHE PATENTSCHRIFT

(11) **EP 2 737 206 B1**
(45) Veröffentlichungstag und Bekanntmachung des Hinweises auf die Patenterteilung: **29.07.2015**
(21) Anmeldenummer: 11757609.0
(22) Anmeldetag: 15.09.2011
(51) Int. Cl.: F03D 9/00, H02J 3/38, F03D 7/02, H02J 3/18, F03D 7/04

(54) **VERFAHREN UND ANORDNUNG ZUM EINSPEISEN VON ELEKTRISCHER LEISTUNG AUS EINER WINDENERGIEANLAGE IN EIN WECHSELSPANNUNGSNETZ**
METHOD AND ARRANGEMENT FOR FEEDING ELECTRICAL POWER FROM A WIND ENERGY INSTALLATION INTO AN AC VOLTAGE SYSTEM
PROCÉDÉ ET ENSEMBLE D'ALIMENTATION D'UN RÉSEAU DE TENSION ALTERNATIVE EN ÉNERGIE ÉLECTRIQUE PROVENANT D'UNE ÉOLIENNE

(43) Veröffentlichungstag der Anmeldung: 04.06.2014
(73) Patentinhaber: Siemens Aktiengesellschaft, 80333 München (DE)
(72) Erfinder: STROBL, Bernhard, 91080 Uttenreuth (DE)
(86) Internationale Anmeldenummer: PCT/EP2011/065998
(87) Internationale Veröffentlichungsnummer: WO 2013/037412

(56) Entgegenhaltungen:
- EP-A1- 1 512 869
- DE-A1-102004 048 341
- US-A1- 2008 265 577
- US-A1- 2009 218 817

## Beschreibung

Es ist bekannt, mittels einer Windenergieanlage elektrische Leistung zu gewinnen und diese Leistung über eine Energieübertragungsstrecke in ein Wechselspannungs-Energieversorgungsnetz einzuspeisen. Dabei kann es sich bei der Windenergieanlage um einen einzigen Windgenerator oder um mehrere Windgeneratoren handeln, die dann einen sog. Windpark bilden. Die Leistungsübergabe an das Wechselspannungsnetz erfolgt an einem gemeinsamen Kopplungspunkt, der auch als PCC (point of common coupling) bezeichnet wird.

Hinsichtlich der Einspeisung von elektrischer Leistung in einen Kopplungspunkt werden von dem jeweiligen Betreiber des Wechselspannungsnetzes Anforderungen bezüglich der Qualität der eingespeisten elektrischen Leistung gestellt, die seitens der Windenergieanlage eingehalten werden müssen. Dazu gehört unter anderem, dass von der Windenergieanlage der Kopplungspunkt mit Blindleistung versorgt werden muss. Die Versorgung kann dabei je nach Situation am Kopplungspunkt in einer Einspeisung oder Absorption von Blindleistung bestehen.

Diese Anforderungen sind bisher mittels Blindleistungskompensationsanlagen erfüllt worden, die zuschaltbare Induktivitäten und Kapazitäten aufweisen und sehr aufwändig sind.

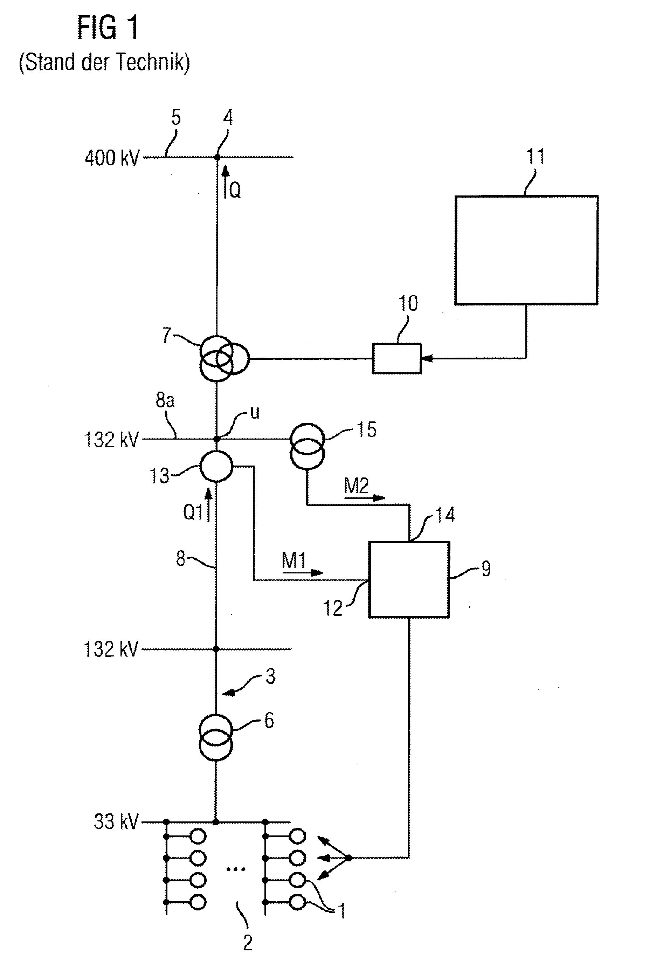

Es ist auch ein Verfahren bzw. eine Anordnung zum Einspeisen von elektrischer Leistung aus einer Windenergieanlage in ein Wechselspannungsnetz offenkundig benutzt, wie es aus Fig. 1 hervor geht. In dieser Figur ist schematisch eine aus mehreren Windturbinen 1 bestehende Windenergieanlage 2 gezeigt, die beispielsweise auf See angeordnet ist. Über eine Energieübertragungsstrecke 3 ist die Windenergieanlage 2 mit einem gemeinsamen Kopplungspunkt 4 mit einem Wechselspannungsnetz 5 verbunden. Die Energieübertragungsstrecke 3 ist dabei einerseits durch einen anlageseitigen Transformator 6 und anderseits durch einen netzseitigen Dreiwicklungstransformator 7 begrenzt; zwischen beiden Transformatoren liegt ein Kabel 8, das an eine Sammelschiene 8a angeschlossen ist.

Wie die Fig. 1 ferner zeigt, ist die bekannte Anordnung mit einer Regelungseinrichtung 9 für die Windenergieanlage 1 versehen, die dafür sorgt, dass die am gemeinsamen Kopplungspunkt 4 jeweils abgegebene Blindleistung Q den jeweiligen Anforderungen des Betreibers des Wechselspannungsnetzes 5 entspricht. Dazu trägt bei der bekannten Anordnung auch eine SVC (Static Var Compensator)-Blindleistungskompensationseinrichtung 10 bei, zu der eine SVC-Steuerungseinrichtung 11 gehört. Ausgangsseitig ist die SVC-Steuereinrichtung 11 mit der SVC-Blindleistungskompensationseinrichtung 10 verbunden.

Die Regelungseinrichtung 9 ist mit einem Eingang 12 an eine Messeinrichtung 13 zur Erfassung einer der Blindleistung auf der Energieübertragungsstrecke 8 proportionalen Messgröße M1 angeschlossen; ein weiterer Eingang 14 der Regelungseinrichtung 9 ist mit einer Messwerterfassungseinrichtung 15 in Form eines Spannungswandlers verbunden, um eine weitere der Spannung an der Sammelschiene 8a proportionale Messgröße M2 zu gewinnen.

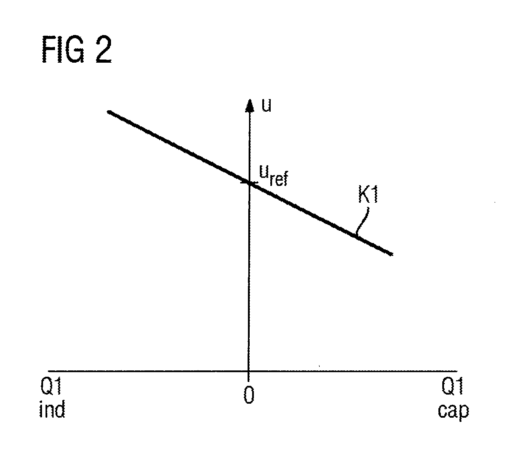

Bei der bekannten Anordnung lässt sich die Blindleistung Q am gemeinsamen Kopplungspunkt 4 so regeln, dass sie den jeweiligen Netzanforderungen entspricht. Dabei absorbiert die Windenergieanlage 1 bei einer über einem Referenzwert Uref liegenden Spannung U auf der Niederspannungsseite des netzseitigen Transformators 7 (vgl. Fig. 2) Blindleistung Q1 (induktiver Bereich ind der Kennlinie K1 gemäß Fig. 2); bei einer unterhalb des Referenzwertes Uref liegenden Spannung U wird Blindleistung Q1 eingespeist (kapazitiver Bereich cap der Kennlinie K1). Die in Fig. 2 gezeigte Kennlinie K1 lässt erkennen, dass die Spannung U auf der Niederspannungsseite des netzseitigen Transformators 7 vom induktiven Bereich und zum kapazitiven Bereich cap hin abfällt.

Der Erfindung liegt die Aufgabe zugrunde, ausgehend von dem bei der bekannten Anordnung durchgeführten Verfahren ein Verfahren vorzuschlagen, mit dem sich eine Anordnung zum Einspeisen von elektrischer Leistung aus einer Windenergieanlage in ein Wechselspannungsnetz besonders kostengünstig betreiben lässt.

Zur Lösung dieser Aufgabe dient ein Verfahren zum Betreiben einer Anordnung zum Einspeisen von elektrischer Leistung aus einer Windenergieanlage in ein Wechselspannungsnetz über eine einerseits von einem anlageseitigen Transformator und anderseits von einem netzseitigen Transformator mit angeschlossener Blindleistungskompensationseinrichtung begrenzten Energieübertragungsstrecke an einem gemeinsamen Kopplungspunkt von Energieübertragungsstrecke und Wechselspannungsnetz unter Verwendung einer die Windenergieanlage steuernden Regelungseinrichtung, die eingangsseitig mit einer der Blindleistung auf der Energieübertragungsstrecke proportionalen Größe und einer weiteren Messgröße beaufschlagt wird, bei dem erfindungsgemäß
als weitere Messgröße ein am Ausgang der Blindleistungskompensationseinrichtung gewonnenes Messsignal verwendet wird; als Regelungseinrichtung wird eine Regelungseinrichtung mit einer derartigen Reglungskennlinie verwendet wird, dass die Spannung auf der Niederspannungsseite des netzseitigen Transformators in Abhängigkeit von der Blindleistung auf der Energieübertragungsstrecke vom induktiven Bereich zum kapazitiven Bereich hin ansteigt.

Ein wesentlicher Vorteil des erfindungsgemäßen Verfahrens gegenüber dem bekannten Verfahren besteht darin, dass durch die Berücksichtigung eines aus der Ausgangsgröße der Blindleistungskompensationseinrichtung gewonnenen Messsignals im stetigen Betrieb eine Korrelation zwischen der eingespeisten Blindleistung am gemeinsamen Kopplungspunkt und dem Messsignal gegeben ist; ein störender Einfluss durch einen üblicherweise vorgesehenen Stufensteller für die Anzapfungen des netzseitigen Transformators ist damit vermieden.

Auch das dynamische Verhalten ist verbessert, weil bei dem erfindungsgemäßen Verfahren die Windenergieanlage und die Blindleistungskompensationseinrichtung nicht gegeneinander arbeiten. Speist nämlich bei dem bekannten Verfahren beispielsweise die Blindleistungskompensationseinrichtung Blindleistung ein, dann kann dort die Spannung auf der Niederspannungsseite des netzseitigen Transformators in Abhängigkeit von der Kurzschlussimpedanz dieses Transformators ansteigen oder abfallen. Wenn eine Blindleistungseinspeisung zu einer Erhöhung der Spannung führt, dann absorbiert die Windenergieanlage einen gewissen Anteil der Blindleistung; die Windenergieanlage arbeitet somit gegen die Blindleistungskompensationseinrichtung. Die bekannte Anordnung kann daher nur spannungsgesteuert arbeiten, wenn die Blindleistungskompensationseinrichtung relativ groß ausgeführt ist. Im Vergleich dazu kommt das erfindungsgemäße Verfahren mit einer vergleichsweise kleinen Blindleistungskompensationseinrichtung aus.

Der vorliegenden Erfindung liegt der Gedanke zugrunde, die Ausgangsgröße der Blindleistungskompensationseinrichtung zur Regelung heran zu ziehen, obwohl der Einfluss der Windenergieanlage auf diese Größe sehr klein ist. Die Ausgangsgröße lässt sich jedoch als Anzeichen dazu benutzten, ob die Blindleistungskompensationseinrichtung Blindleistung in das Wechselspannungsnetz einspeist oder absorbiert. Bei einer Einspeisung ist die Ausgangsgröße höher als bei einer Absorption, weshalb diese Größe als weitere Messgröße bzw. Messsignal für die Regelungseinrichtung benutzt werden kann.

Bei dem erfindungsgemäßen Verfahren kann das Messsignal in verschiedener Weise gewonnen werden. Als besonders vorteilhaft wird es angesehen, wenn das Messsignal aus der Spannung am Ausgang Blindleistungskompensationseinrichtung gewonnen wird.

Vorteilhaft kann es aber auch sein, das Messsignal aus der Blindleistung am Ausgang der Blindleistungskompensationseinrichtung zu gewinnen.

Die Erfindung betrifft ferner eine Anordnung zum Einspeisen von elektrischer Leistung aus einer Windenergieanlage in ein Wechselspannungsnetz über eine einerseits von einem anlageseitigen Transformator und anderseits von einem netzseitigen Transformator mit angeschlossener Blindleistungskompensationseinrichtung begrenzten Energieübertragungsstrecke an einem gemeinsamen Kopplungspunkt von Energieübertragungsstrecke und Wechselspannungsnetz mit einer Regelungseinrichtung für die Windenergieanlage , wobei die Regelungseinrichtung an einem Eingang mit einer der Blindleistung auf der Energieübertragungsstrecke proportionalen Größe und an einem weiteren Eingang mit einer weiteren Messgröße beaufschlagt ist; eine solche Anordnung ist in der Figur 1 als Stand der Technik dargestellt.

Um eine solche Anordnung vergleichsweise kostengünstig herstellen zu können, ist erfindungsgemäß der weitere Eingang der Regelungseinrichtung an eine mit dem Ausgang der Blindleistungskompensationseinrichtung verbundene Messwerteerfassungseinrichtung angeschlossen, und die Regelungseinrichtung weist eine derartige Reglungskennlinie auf, dass die Spannung auf der Niederspannungsseite des netzseitigen Transformators in Abhängigkeit von der Blindleistung auf der Energieübertragungsstrecke vom induktiven Bereich zum kapazitiven Bereich hin ansteigt.

Eine solche erfindungsgemäß ausgeführte Anordnung weist dieselben Vorteile auf, die oben bereits im Zusammenhang mit den Ausführungen zu dem erfindungsgemäßen Verfahren angegeben worden sind.

Die Messwerterfassungseinrichtung kann bei der erfindungsgemäßen Anordnung unterschiedlich ausgeführt sein. Besonders vorteilhaft erscheint es, wenn die Messwerteerfassungseinrichtung ein Spannungswandler oder eine Blindleistungsmesseinrichtung ist.

Zur weiteren Erläuterung der Erfindung sind in
Fig. 3 ein Ausführungsbeispiel der erfindungsgemäßen Anordnung und in
Fig. 4 eine bei der erfindungsgemäßen Anordnung verwendete Regelkennlinie
dargestellt.

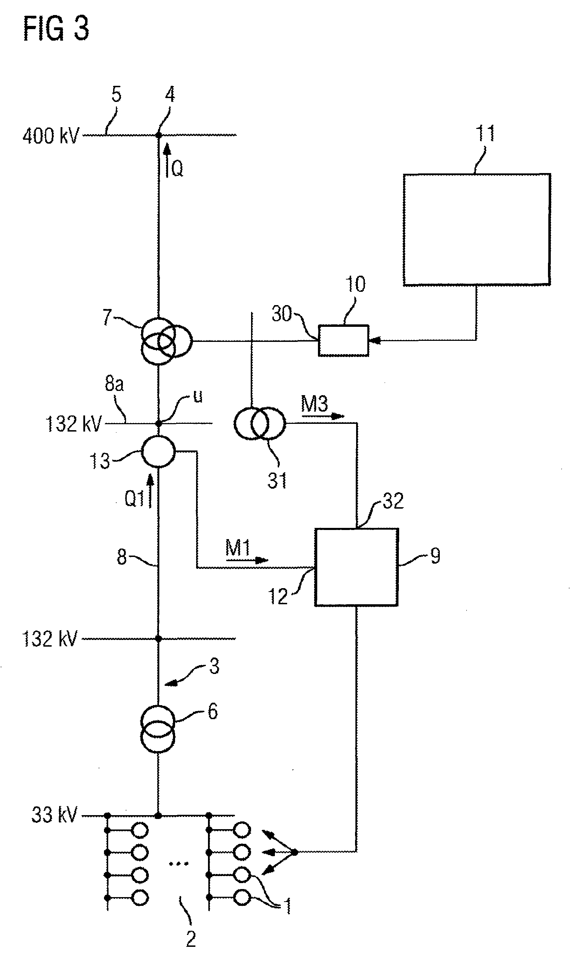

Die in Figur 3 gezeigte Anordnung ist hinsichtlich ihrer mit der Anordnung nach Fig. 1 übereinstimmenden Elemente mit den gleichen Bezugzeichen versehen.

Die Anordnung gemäß Fig. 3 unterscheidet sich von der Anordnung gemäß Fig. 1 dadurch, dass an den Ausgang 30 der Blindleistungskompensationseinrichtung 10 eine Messwerterfassungseinrichtung in form eines Spannungswandlers 31 primärseitig angeschlossen ist. Dieser Spannungswandler 31 ist sekundärseitig mit einem Eingang 32 der Regelungseinrichtung 9 verbunden und gibt ein Messsignal M3 an die Regelungseinrichtung 9 ab.

Das Messsignal M3 ist somit der Spannung am Ausgang der Blindleistungskompensationseinrichtung 10 proportional. Diese Spannung wird als Anzeichen dafür verwendet, ob die Blindleistungskompensationseinrichtung 10 gerade Blindleistung in das Wechselspannungsnetz einspeist oder Blindleistung absorbiert. Findet gerade eine Einspeisung statt, dann ist die Spannung am Ausgang 30 der Blindleistungskompensationseinrichtung 10 höher als im Falle eine Absorption. Daher ist das Messsignal M3 als Eingangssignal für die Regelungseinrichtung 9 geeignet.

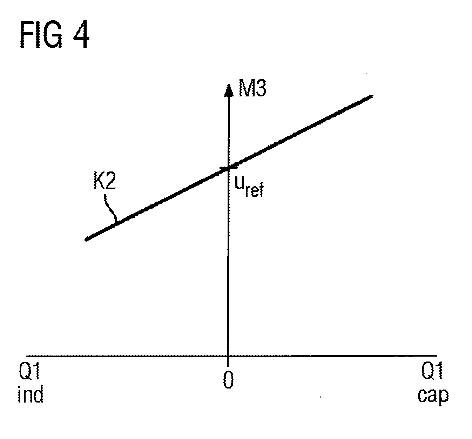

Wie Fig. 4 zeigt, wird bei der Anordnung gemäß Fig. 4 eine Regelungseinrichtung 9 verwendet, die zu einer im Vergleich zur Kennlinie gemäß Fig. 2 inversen Kennlinie K2 über der Blindleistung Q1 auf der Energieübertragungsstrecke 8 führt. Bei der Kennlinie K2 steigt das Messsignal M3 vom induktiven Bereich und zum kapazitiven Bereich cap an.

Insgesamt ergibt sich, dass mit dem erfindungsgemäßen Verfahren bzw. mit der erfindungsgemäßen Anordnung erreicht wird, dass die Windenergieanlage 2 sowohl beim Einspeisen als auch beim Absorbieren von Blindleistung die Blindleistungskompensationseinrichtung 10 unterstützt. Speist nämlich die Blindleistungskompensationseinrichtung 10 Blindleistung ein, dann ist die Spannung an ihrem Ausgang 30 relativ hoch, was gemäß Kennlinie K2 nach Fig. 4 zu einer zusätzlichen Einspeisung von Blindleistung seitens der Windenergieanlage 2 führt. Entsprechendes gilt im Falle von Absorption von Blindleistung. Die Windenergieanlage 2 unterstützt also jeweils die Arbeitsweise der Blindleistungskompensationseinrichtung 10, weshalb die Blindleistungskompensationseinrichtung 10 vergleichsweise klein sein kann.

## Patentansprüche

1. Verfahren zum Betreiben einer Anordnung zum Einspeisen von elektrischer Leistung aus einer Windenergieanlage (2) in ein Wechselspannungsnetz (5) über eine einerseits von einem anlageseitigen Transformator (6) und anderseits von einem netzseitigen Transformator (7) mit angeschlossener Blindleistungskompensationseinrichtung (10) begrenzten Energieübertragungsstrecke (8) an einem gemeinsamen Kopplungspunkt (4) von Energieübertragungsstrecke (8) und Wechselspannungsnetz (5) unter Verwendung einer die Windenergieanlage(2) steuernden Regelungseinrichtung (9), die eingangsseitig mit einer der Blindleistung auf der Energieübertragungsstrecke proportionalen Größe (M1) und einer weiteren Messgröße beaufschlagt wird,
**dadurch gekennzeichnet, dass**
als weitere Messgröße ein am Ausgang (30) der Blindleistungskompensationseinrichtung (10)gewonnenes Messsignal (M3) verwendet wird und als Regelungseinrichtung eine Regelungseinrichtung (9) mit einer derartigen Reglungskennlinie (K2) verwendet wird, dass die Spannung (U) auf der Niederspannungsseite des netzseitigen Transformators (7) in Abhängigkeit von der Blindleistung (Q1) auf der Energieübertragungsstrecke (8) vom induktiven Bereich (ind) zum kapazitiven Bereich (cap) hin ansteigt.

2. Verfahren nach Anspruch 1, **dadurch gekennzeichnet, dass** das Messsignal (M3) aus der Spannung am Ausgang (30) der Blindleistungskompensationseinrichtung (10) gewonnen wird.

3. Verfahren nach Anspruch 1, **dadurch gekennzeichnet, dass** das Messsignal aus der Blindleistung am Ausgang Blindleistungskompensationseinrichtung gewonnen wird.

4. Anordnung zum Einspeisen von elektrischer Leistung aus einer Windenergieanlage (2) in ein Wechselspannungsnetz (5) über eine einerseits von einem anlageseitigen Transformator (6) und anderseits von einem netzseitigen Transformator (7) mit angeschlossener Blindleistungskompensationseinrichtung (10) begrenzten Energieübertragungsstrecke (8) an einem gemeinsamen Kopplungspunkt (4) von Energieübertragungsstrecke (8) und Wechselspannungsnetz (5) mit einer Regelungseinrichtung (9) für die Windenergieanlage (2), wobei die Regelungseinrichtung (9) an einem Eingang (12) mit einer der Blindleistung (Q1) auf der Energieübertragungsstrecke (8) proportionalen Größe (M1) und an einem weiteren Eingang mit einer weiteren Messgröße beaufschlagt ist,
**dadurch gekennzeichnet, dass**
der weitere Eingang (32) der Regelungseinrichtung (9) an eine mit dem Ausgang (30) der Blindleistungskompensationseinrichtung (10) verbundene Messwerteerfassungseinrichtung (31) angeschlossen ist und die Regelungseinrichtung (9) eine derartige Reglungskennlinie (K2) aufweist, dass die Spannung (U) auf der Niederspannungsseite des netzseitigen Transformators (7) in Abhängigkeit von der Blindleistung (Q1) auf der Energieübertragungsstrecke (8)vom induktiven Bereich (ind) zum kapazitiven Bereich (cap) hin ansteigt.

5. Anordnung nach Anspruch 4, **dadurch gekennzeichnet, dass** die Messwerteerfassungseinrichtung ein Spannungswandler ist.

6. Anordnung nach Anspruch 4, **dadurch gekennzeichnet, dass** die Messwerteerfassungseinrichtung eine Blindleistungsmesseinrichtung ist.

## Claims

1. Method for operating an arrangement for feeding electrical power from a wind energy installation (2) into an AC voltage system (5) via an energy transmission path (8), which is limited on one side by an installation-side transformer (6) and on the other side by a system-side transformer (7) with a connected power factor correction device (10), at a point of common coupling (4) between the energy transmission path (8) and the AC voltage system (5) using a closed-loop control device (9) controlling the wind energy installation (2), to which closed-loop control device a variable (M1) which is proportional to the reactive power on the energy transmission path and a further measured variable are applied on the input side,
**characterized in that**
a measurement signal (M3) obtained at the output (30) of the power factor correction device (10) is used as the further measured variable, and a closed-loop control device (9) with such a control characteristic (K2) that the voltage (U) on the low-voltage side of the system-side transformer (7) increases from the inductive range (ind) to the capacitive range (cap) depending on the reactive power (Q1) on the energy transmission path (8) is used as the closed-loop control device.

2. Method according to Claim 1, **characterized in that** the measurement signal (M3) is obtained from the voltage at the output (30) of the power factor correction device (10).

3. Method according to Claim 1, **characterized in that** the measurement signal is obtained from the reactive power at the output of the power factor correction device.

4. Arrangement for feeding electrical power from a wind energy installation (2) into an AC voltage system (5) via an energy transmission path (8), which is limited on one side by an installation-side transformer (6) and on the other side by a system-side transformer (7) with a connected power factor correction device (10), at a point of common coupling (4) between the energy transmission path (8) and the AC voltage system (5) with a closed-loop control device (9) for the wind energy installation (2), wherein a variable (M1) which is proportional to the reactive power (Q1) on the energy transmission path (8) is applied to the closed-loop control device (9) at one input (12) and a further measured variable is applied to the closed-loop control device at a further input,
**characterized in that**
the further input (32) of the closed-loop control device (9) is connected to a measured value detection device (31), which is connected to the output (30) of the power factor correction device (10), and the closed-loop control device (9) has such a control characteristic (K2) that the voltage (U) on the low-voltage side of the system-side transformer (7) increases from the inductive range (ind) to the capacitive range (cap) depending on the reactive power (Q1) on the energy transmission path (8).

5. Arrangement according to Claim 4, **characterized in that** the measured value detection device is a voltage transformer.

6. Arrangement according to Claim 4, **characterized in that** the measured value detection device is a reactive power measuring device.

## Revendications

1. Procédé pour faire fonctionner un montage pour injecter de la puissance électrique d'une éolienne ( 2 ) dans un réseau ( 5 ) de tension alternative par l'intermédiaire d'un trajet ( 8 ) de transport d'énergie délimité, d'une part, par un transformateur ( 6 ) du côté de l'éolienne et, d'autre part, par un transformateur ( 7 ) du côté du réseau ayant un dispositif ( 10 ) de compensation de puissance réactive raccordée, l'injection se faisant en un point ( 4 ) de couplage commun du trajet ( 8 ) de transport d'énergie et du réseau ( 5 ) de tension alternative, en utilisant un dispositif ( 9 ) de régulation, qui commande l'éolienne ( 2 ) et qui est alimenté du côté de l'entrée par une grandeur ( M1 ) proportionnelle à la puissance réactive sur le trajet de transport d'énergie et par une autre grandeur de mesure,
**caractérisé en ce que**
on utilise comme autre grandeur de mesure un signal ( M3 ) de mesure obtenu à la sortie ( 30 ) du dispositif ( 10 ) de compensation de la puissance réactive et comme dispositif de régulation un dispositif ( 9 ) de régulation ayant une caractéristique ( K2 ) de régulation telle que la tension ( U ) du côté de la basse tension du transformateur ( 7 ) du côté du réseau s'élève de la région ( ind ) inductive à la région (cap) capacitive en fonction de la puissance ( Q1 ) réactive sur le trajet ( 8 ) de transport d'énergie.

2. Procédé suivant la revendication 1, **caractérisé en ce que** l'on obtient le signal ( M3 ) de mesure à partir de la tension à la sortie ( 30 ) du dispositif ( 10 ) de compensation de la puissance réactive.

3. Procédé suivant la revendication 1, **caractérisé en ce que** l'on obtient le signal de mesure à partir de la puissance réactive à la sortie du dispositif de compensation de la puissance réactive.

4. Montage pour injecter de la puissance électrique d'une éolienne ( 2 ) dans un réseau ( 5 ) de tension alternative par l'intermédiaire d'un trajet ( 8 ) de transport d'énergie délimité, d'une part, par un transformateur ( 6 ) du côté de l'éolienne et, d'autre part, par un transformateur ( 7 ) du côté du réseau ayant un dispositif ( 10 ) de compensation de la puissance réactive qui y est raccordé, l'injection s'effectuant en un point ( 4 ) de couplage commun du trajet ( 8 ) de transport d'énergie et du réseau ( 5 ) de tension alternative par un dispositif ( 9 ) de régulation de l'éolienne ( 2 ), le dispositif ( 9 ) de régulation étant alimenté à une entrée ( 12 ) par une grandeur (mil) proportionnelle a la puissance ( Q1 ) réactive sur la ligne ( 8 ) de transport d'énergie et à une autre entrée par une autre grandeur de mesure,
**caractérisé en ce que**
l'autre entrée ( 32 ) du dispositif ( 9 ) de régulation est reliée à un dispositif ( 31 ) de détection de valeurs de mesure relié à la sortie ( 30 ) du dispositif ( 10 ) de compensation de la puissance réactive et le dispositif ( 9 ) de régulation a une caractéristique ( K2 ) de régulation telle que la tension ( U ) du côté de la basse tension du transformateur ( 7 ) du côté du réseau s'élève de la région ( ind ) inductive à la région (cap) capacitive en fonction de la puissance ( Q1 ) réactive sur le trajet ( 8 ) de transport d'énergie.

5. Montage suivant la revendication 4, **caractérisé en ce que** le dispositif de détection de valeurs de mesure est un convertisseur de tension.

6. Montage suivant la revendication 4, **caractérisé en ce que** le dispositif de détection de valeurs de mesure est un dispositif de mesure de la puissance réactive.
